# EUROPEAN PATENT APPLICATION

(11) **EP 4 819 204 A1**
(43) Date of publication of application: **07.10.2026**
(21) Application number: 25460012.5
(22) Date of filing: 02.04.2025
(51) Int. Cl.: H01L 23/44, H01L 23/473, H05K 7/20

(54) **COOLING ARRANGEMENT**

(71) Applicant: TRUMPF Huettinger Sp. z o.o., 05-220 Zielonka (PL)
(72) Inventor: The designation of the inventor has not yet been filed
(74) Representative: Trumpf Patentabteilung

(57) **Abstract**

Cooling arrangement (1) comprising:
• an integrated power module (10);
• a container (2), in which the integrated power module (10) is arranged at least partly; and
• a dielectric heat transfer coolant (3), which is filled in the container (2) at least partly and which is in direct contact with the integrated power module (10) at least partly;
wherein the integrated power module (10) comprises:
i. a substrate (11), wherein the substrate (11) comprises: a first layer (70), a second layer (72), and a third layer (74), wherein the second layer (72) is placed between the first layer (70) and the third layer (74),
ii. multiple components (5) placed on the substrate (11), connected to each other by conductive paths (6), capable of generating heat during operation,
iii. a fluid inlet (77) for a cooling fluid (9), and
iv. a fluid outlet (79) for the cooling fluid (9).

## Description

The invention relates to a cooling arrangement for an integrated power module, e.g., for a plasma supply unit, and a plasma process.

A "plasma process" designates any process in which a plasma is used, for example, a plasma etching process, a plasma deposition process, a plasma cleaning process, a plasma surface treatment process, a plasma polymerization process.

In WO 2010/091696 A1 is disclosed a module for a plasma supply unit for supplying a plasma that is used in a plasma treatment or in a gas laser. The module comprises a substrate, on which one or more conductor tracks are provided as well as a GaN semiconductor switching element that is connected to at least one conductor track and an associated driver. The paten description describes the cooling of the power module, but due to the increasing power of the power modules, the cooling used so far is insufficient.

Power modules are becoming more and more desirable, and it is required that they have more and more power at the smallest possible size. The size of integrated power module may be for reducing the overall footprint on the circuit board. That is why it is so important to cool them effectively, for enhance heat dissipation and reduce thermal resistance.

This application addresses the problem of inefficient heat management for integrated power modules used in power supplies for plasma processes. The integrated power module refers to a compact and highly efficient assembly that combines multiple power electronic components and circuits into a single unit. This module typically includes electronic components, power semiconductor devices, such as insulated-gate bipolar transistors (IGBTs) or metal-oxide-semiconductor field-effect transistors (MOSFETs), along with associated gate drivers, protection circuits, and thermal management systems.

The object of the present invention is a cooling arrangement for an integrated power module for a plasma supply unit, and a plasma process with high cooling efficiency of the power module.

According to first aspect cooling arrangement comprising an integrated power module and a container. The integrated power module may be arranged at least partly inside the container.

In an aspect, the cooling arrangement comprises a dielectric heat transfer coolant, which is filled in the container at least partly. The dielectric heat transfer coolant may be in direct contact with the integrated power module at least partly.

The cooling arrangement with integrated power modules and container ensures effective heat transfer from heat-generating multiple components to the dielectric heat transfer coolant, maintaining optimal operating temperatures and preventing overheating.

In an aspect, the integrated power module may comprise a substrate and multiple components placed on the substrate. The multiple components may be connected to each other by conductive paths. The multiple components may be capable to generate heat during operation.

In an aspect, the substrate may comprise a first layer, a second layer and a third layer. The second layer placed between the first layer and the third layer.

In an aspect, the third layer may comprise of several sheets of metal. Several sheets of metal may be understood as at least two metal sheets, preferred 10 or more, such as around 20.

The substrate with three layers provides improved mechanical strength and durability, ensuring reliable performance under various operating conditions. Each layer can be tailored to specific thermal properties, enhancing heat dissipation and maintaining optimal temperatures for the components mounted on the substrate. The layers can be designed to provide effective electrical insulation, preventing short circuits and ensuring safe operation of electronic devices

In an aspect, the substrate may comprise a fluid inlet for a cooling fluid, and a fluid outlet for cooling fluid. This cooling fluid may be understood as a separate cooling fluid, not in direct contact with the dielectric heat transfer coolant.

In such a way, the above-mentioned object can be solved even better.

In an aspect, the first layer may be made of copper.

In such a way, the above-mentioned object can be solved even better.

In an aspect, the second layer may be made of ceramic.

In such a way, the above-mentioned object can be solved even better.

In an aspect, the third layer may be made of copper or aluminum.

In such a way, the above-mentioned object can be solved even better.

In an aspect, the first layer may comprise of several first layer areas. These areas may be used as contact pads for the components and as transmission lines for electrical contact between the components.

In such a way, the above-mentioned object can be solved even better.

In an aspect, the substrate may be metalized by direct bonded copper, in particular on both sides. The first layer and the third layer may be arranged in such a way on both sides of the second layer.

In such a way, the above-mentioned object can be solved even better.

In an aspect, the heat transfer coolant may be a fluorocarbon-based fluid.

In such a way, the above-mentioned object can be solved even better.

In an aspect, the substrate may be configured to work as a fluid flowable heatsink with a cooling fluid. Such a design refers to a designed base material that functions as a heatsink by allowing the flow of cooling fluid through its structure. The cooling fluid absorbs thermal energy from the substrate and carries it away, maintaining optimal operating temperatures. The fluid flowable heatsink design ensures efficient thermal management, reducing the risk of overheating and improving the performance and reliability of the system.

In such a way, the above-mentioned object can be solved even better.

In an aspect, the cooling arrangement is configured to use water or dielectric heat transfer coolant as cooling fluid. This cooling fluid may be understood as a separate cooling fluid, not in direct contact with the dielectric heat transfer coolant

In such a way, the above-mentioned object can be solved even better.

The dielectric heat transfer coolant and cooling fluid may provide electrical insulation, preventing short circuits and ensuring safe operation of electronic components. Usage of coolant may be thermally stable, maintaining their properties over a wide range of temperatures and enhancing consistent cooling performance.

In such a way, the above-mentioned object can be solved even better.

In an aspect, the fluid inlet and/or the fluid outlet have a seal arranged to protect against cooling fluid leakage.

In such a way, the above-mentioned object can be solved even better.

In an aspect, the cooling arrangement comprises multiple components of the integrated power module may be one or more or a combination of the following: a power input, a power output, a switch element, a source contact, a drain contact, a gate contact , a switch power input, a switch power output, a signal input, a driver circuit, a driver signal contact, a driver input, a driver output, a driver gate contact, a coupling capacitor.

In such a way, the above-mentioned object can be solved even better.

In an aspect, the third layer and/or the heatsink comprise(s) a cooling channel.

In such a way, the above-mentioned object can be solved even better.

In an aspect, the third layer and/or the heatsink comprise(s) cooling fins.

In such a way, the above-mentioned object can be solved even better.

In an aspect, the cooling fins have direct contact to the dielectric heat transfer coolant.

In such a way, the above-mentioned object can be solved even better.

In an aspect, the cooling arrangement comprises conductive paths of the integrated power module may be one or more or a combination of the following: a source path, a drain path, a driver input path, a driver output path, a signal path, a gate path.

In such a way, the above-mentioned object can be solved even better.

In an aspect, multiple components and conductive paths of the integrated power module may be arranged directly on the substrate.

In such a way, the above-mentioned object can be solved even better.

In an aspect, a second substrate is arranged at the heatsink. Such a substrate may also be metalized by direct bonded copper, in particular on both sides.

In such a way, the above-mentioned object can be solved even better.

Further details and advantageous embodiments of the invention can be found in the following description, based on which embodiments of the invention are further described and explained.

In such a way, the above-mentioned object can be solved even better.

The present disclosure is illustrated by way of example and not limited in the accompanying figures in which like reference numerals indicate similar elements.

In such a way, the above-mentioned object can be solved even better.
Fig. 1 shows a schematic of the cooling arrangement for integrated power module with schematic circuit of integrated power module and a perspective view of one example.
Fig. 2 shows a side view of the integrated power module with cooling arrangement.
Fig. 3 - 4 each show a perspective view on two different examples of the integrated power module with cooling arrangement.
Fig. 5 shows a schematic view of a plasma supply unit with cooling arrangement
Fig. 6 shows a schematic view of a plasma process.

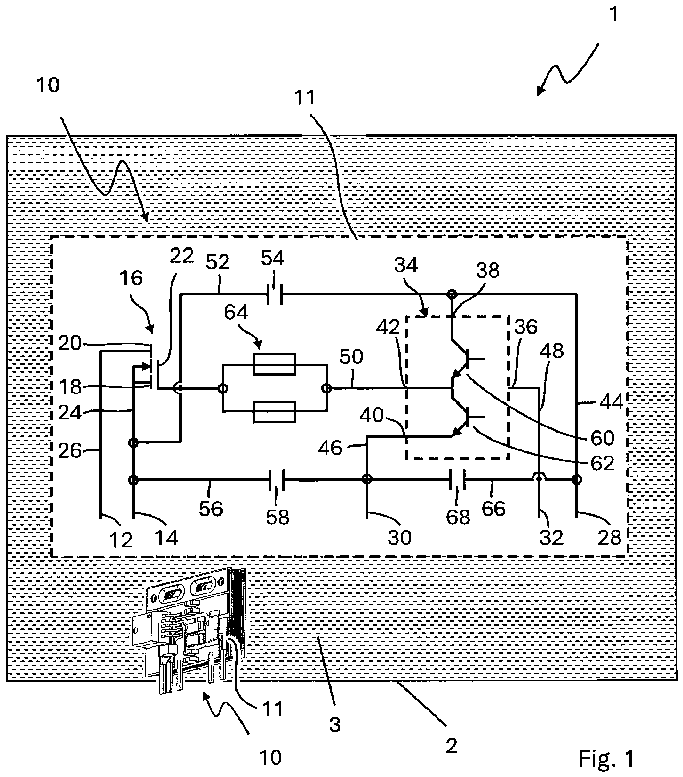

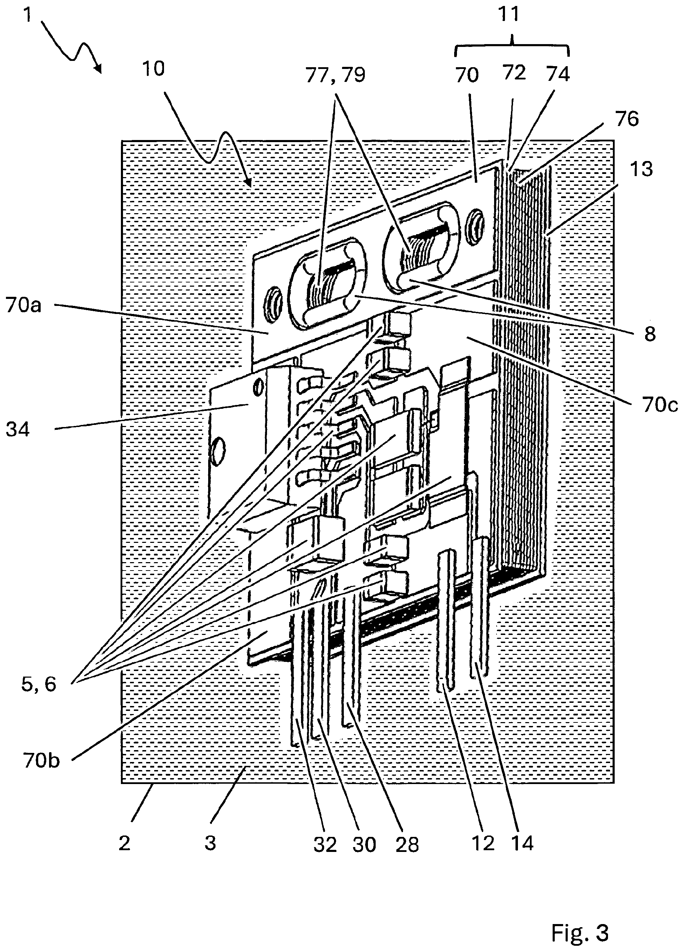

Fig. 1 shows a schematic of the cooling arrangement 1 for integrated power module 10 with an example of a circuit schematic of the integrated power module 10 and a perspective view of one example of the integrated power module 10. The integrated power module 10 is arranged inside a container 2 filled with a dielectric heat transfer coolant 3. That example of the integrated power module 10 is explained in more detail in the description of Fig. 3. In Fig. 1 the integrated power module 10 for a plasma process comprises a substrate 11 made of ceramic material with both sides metalized by direct bonded copper.

A container 2 refers to a vessel or enclosure designed to hold and manage a cooling fluid used in cooling arrangements. The container 2 may be constructed from materials that provide structural integrity and compatibility with the coolant, ensuring safe and efficient operation. The container 2 may include features such as pressure relief valves, and temperature sensors to facilitate the circulation, monitoring, and regulation of the cooling fluid. The container 2 can be designed to accommodate various types of coolants, including liquids and gases, providing flexibility in choosing the most suitable coolant for specific applications. The enclosed design simplifies maintenance and refilling of the coolant, ensuring long-term reliability and performance. The container 2 can be easily scaled to different sizes and capacities, making it suitable for a wide range of power modules.

The dielectric heat transfer coolant 3 refers to a specialized fluid designed to absorb and dissipate heat while providing electrical insulation. The dielectric heat transfer coolant 3 are non-flammable, low-toxic, dielectric fluids with relatively low boiling point (below 100°C). The dielectric heat transfer coolant is typically composed of materials with high thermal conductivity, low viscosity, and excellent dielectric properties to prevent electrical conduction. It may also include additives to enhance its thermal stability, reduce oxidation, and prevent corrosion. The dielectric heat transfer coolant 3 may be also ethylene glycol, propylene glycol, mineral oil, silicone oils, fluorocarbon oils. The coolant ensures effective heat dissipation while maintaining the electrical integrity of the components it cools.

The use of the dielectric heat transfer coolant 3 may provide the advantage of maintaining fluidity, ensuring effective heat management without electrical interference.

The integrated power module 10 comprises a power input 12 and a power output 14. The power input 12 and/or the power output 14 are made by contact pins, preferably configured to be connected to a main-PCB. With main-PCB should be understood an electronical device comprising a printed circuit board (PCB), electronic parts, such as resistors, inductivities, capacitors, integrated circuits, diodes transistors, copper lines and/or planes to connect those parts, and a possibility to integrate one or more of the power modules 10. The power input 12 and/or the power output 14 preferably act as power terminals.

The power module 10 further comprises a switch element 16, in particular a bare semiconductor die, preferably made from a SiC basis with a source contact 18, a drain contact 20 and a gate contact 22. The switch element 16 is set up to switch between a closing state connecting the source contact 18 and the drain contact 20 and an opening state disconnecting the source contact 18 and the drain contact 20. The switch element 16 is further configured to withstand a voltage equal or higher than 800 V and conduct a current equal or higher than 10 A. The switch element 16 is further configured to be switched with a frequency equal or higher than 200 kHz. The switch element 16 is soldered connected and/or silver sintered on the first layer 70 as a bare die or connected with the first layer 70 by a metal clip. Further, the switch element is connected with the first layer 70 by bonding wires (not shown).

In Fig. 1, the power input 12 and the drain contact 20 are connected via a drain path 26 and the power output 14 and the source contact 18 are connected via a source path 24.

The power module 10 comprises a switch power input 28, a switch power output 30 and a signal input 32. The switch power input 28 and/or the switch power output 30 and/or the signal input 32 are made by contact pins, preferably configured to be connected to a main-PCB. The switch power input 28 and/or the switch power output 30 and/or the signal input 32 act preferably as signal terminals.

The power module 10 further comprises a driver circuit 34 with a driver signal contact 36, a driver input 38, a driver output 40 and a driver gate contact 42. The driver input 38 and the switch power input 28 are connected via a driver input path 44. The driver output 40 and the switch power output 30 are connected via a driver output path 46. The driver signal contact 36 and the signal input 32 are connected via a signal path 48. The driver gate contact 42 and the gate contact 22 are connected via a gate path 50.

The power input 12 and/or the power output 14 and/or the switch element 16 and/or the source contact 18 and/or the drain contact and/or the gate contact and/or the switch power input 28 and/or the switch power output 30 and/or the signal input 32 and/or the driver circuit 34 and/or the driver signal contact 36 and/or the driver input 38 and/or the driver output 40 and/or the driver gate contact 42 are arranged directly on the substrate 11, in particular on the front side of the substrate 11, preferably on the first layer 70.

The integration of the switch element 16, the driver circuit 34 and the coupling capacitors 54, 58, 68 on the front side of the substrate significantly reduces the length of the driver circuit 34 current loop. This allows minimizing stray inductance in the driver circuit 34, which decreases voltage overshoots, ringing on the gate signal and the turn-on/turn-off time.

The driver circuit 34 is set up depending on a signal at the signal input 32 to provide a switch current at the gate contact 22 to put the switch element 16 in the closing state. The driver circuit 34 comprises a first semiconductor element 60, preferably a first transistor, and a second semiconductor element 62, preferably a second transistor. The first semiconductor element 60 is arranged between the driver input 38 and the driver gate contact 42. The second semiconductor element 62 is arranged between the driver output 30 and the driver gate contact 42. Using the semiconductor elements 60, 62, the switch element 16, in particular the gate contact 22, can be connected with the switch power input 28 or the switch power output 30.

By only closing the first semiconductor element 60, the switch power input 28 is connected with the gate contact 22. Then, a switch current can be supplied from the switch power input 28 to the gate contact 22. By only closing the second semiconductor element 62, the switch power output 30 is connected with the gate contact 22. Then, the switch current can flow off from the gate contact 22 to the switch power output 30.

As high-frequency switching is required for some plasma processes, the power module 10 further comprises a first capacitive arrangement 54, a second capacitive arrangement 58 and a third capacitive arrangement 68.

The source path 24 and the switch power input 38 are connected via a first coupling path 52, wherein the first capacitive arrangement 54 is arranged at the first coupling path 52. The first coupling path 52 and the driver input path 28 are arranged in such a way that the switch current to put the switch element 16 in the closing state is provided by the switch power input 28 and the first capacitive arrangement 54. If the switch is to be switched in the closing state, a current should be transferred to the switch in a short time. In a previous cycle, the first capacitive arrangement 54 has charged itself and can provide additional current for switching the switch element 16. Therefore, by closing the first semiconductor element 60, the switch power input 28 and the first capacitive arrangement 54 are connected with the gate contact 22 and supply the switch current. On the one hand, this speeds up shifting and on the other hand, fluctuations in the switch power input 28 can be compensated.

The source path 24 and the switch power output 30 are connected via a second coupling path 56, wherein the second capacitive arrangement 58 is arranged at the second coupling path 56 between the source path 24 and the switch power output 30. The second coupling path 56 and the switch power output 30 are arranged in such a way that the switch current to put the switch element 16 in the opening state discharges to the switch power output 30 and the second capacitive arrangement 58. If the switch is to be switched in the opening state, a current has to be discharged away from the switch element 16 in a short time. Besides the switch power output 30 the second capacitive arrangement 56 provides an additional sink to absorb the current. Therefore, by closing the second semiconductor element 62, the switch power output 30 and the second capacitive arrangement 58 are connected with the gate contact 22 and provide current sinks for discharging the switch current. This further speed up shifting.

The first coupling path 52 and the second coupling path 56 are arranged at a distance to each other. Due to the semiconductor elements 60, 62 the flow-in of the current to the switch element 16 takes another path than the flow-out of the current from the switch element 16. The current flow is split. Therefore, a wide area of the substrate is used to discharge the heat from the components through the layers 70, 72, 74 to the heatsink 76. Thus, the cooling is more efficient. Further, small circulating current means less interference. The equalizing currents remain on the power module 10. This prevents equalizing currents from flowing to other PCBs. The arrangement of the paths 52, 56 comes with a synergy effect of optimized cooling and stable switching (decreased voltage overshoot).

Further the components, in particular the switch element 16 and/or the driver circuit 34 and/or the first coupling path 52 and/or the second coupling path 56 are arranged on the substrate 11 in such a way, that less parasitic inductances occur. This means that there are only minor oscillations during high frequency switching of the switching element 16. Due to the reduced driver circuit loop, ringing on the switch signal can be reduced. Further, the turn-on and turn-off time is significantly decreased.

Further, a resistive arrangement 64, in particular a gate resistor, is arranged at the gate path 50 between the driver gate contact 42 and the gate contact 22. The resistive arrangement 64 of the switch element 16 effectively controls the switching speed, dampens parasitic oscillations, and optimizes efficiency by balancing switching and conduction losses, thus enhancing the overall performance and reliability of the device.

In Fig. 1, the driver input path 44 and the driver output path 46 are connected via a third coupling path 66. A third capacitive arrangement 68 is arranged at the third coupling path 66 between the driver input path 44 and the driver output path 46.

The power module 10 may comprise an additional power output 14b connected to the source path 24 and/or to an additional source path 24b. The additional source path 24b may connect the additional power output 14b also with the source contact 18.

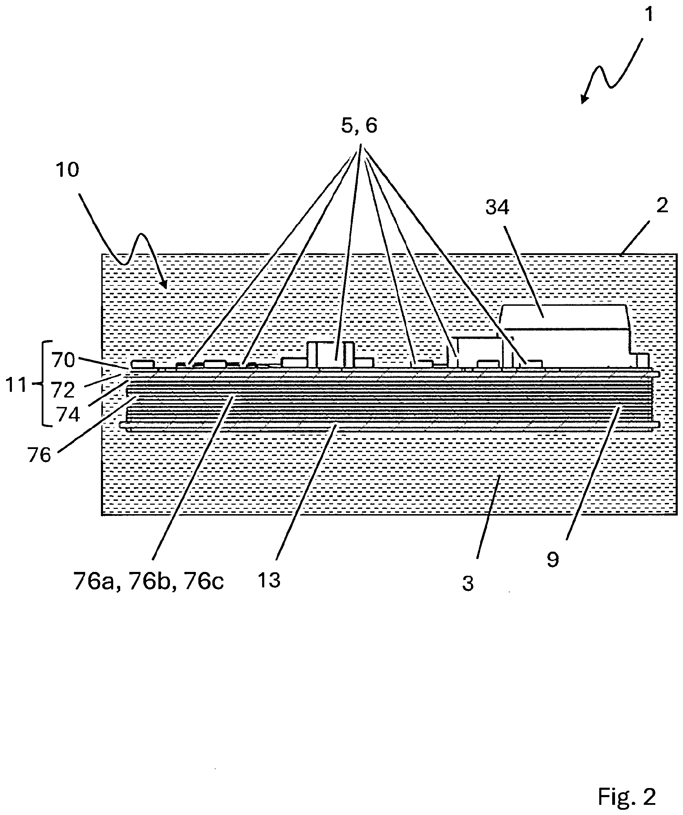

On Fig. 2 is presented the cooling arrangement 1 for the integrated power module 10 showing the container 2 filled with the dielectric heat transfer coolant 3. The integrated power module 10 consists of the substrate 11 comprises a first layer 70 made from copper and a second layer 72 made from ceramic and a third layer 74 made from copper and/or aluminum. The first layer 70 forms a front side of the substrate 11 and the third layer 74 forms a back side of the substrate 11. The second layer 72 is arranged between the first layer 70 and the third layer 74. The first layer 70, second layer 72 and/or the third layer 74 may consist of multiple sheets. At the back side of the substrate a fluid flowable heatsink 76 made from metal sheets 76a, 76b, 76c, in particular copper sheets, is arranged. The heatsink 76 allows a cooling fluid 9 to flow between the metal sheets to cool the integrated power module 10. The heatsink 76 is connected to the third layer 74 in a monolithic way, in particular the third layer 74 and the heatsink 76 are manufactured in a common additive manufactured process. Alternatively, the heatsink 76 is connected by foils pressed in a way like direct copper bonding (DCB) to the third layer 74. At the front side of substrate 11, the integrated power module 10 comprises multiple components 5, a driver circuit 34 and conductive paths 6.

In an aspect, a second substrate 13 is arranged at the heatsink 76. This may be stabilizing the cooling arrangement 1, in particular against bending in temperature differences.

Such a substrate may also be metalized by direct bonded copper, in particular on both sides. This may help to contact the substrate on the heatsink.

A forth layer and a fifth layer may be arranged in the same way on both sides of the second substrate 13 as it was described with the substrate 11. The same effects apply.

The forth layer may be facing to the heatsink side. It may be connected to the heatsink, e.g. by direct bonding copper. This may help to contact the substrate on the heatsink very durable.

The fifth layer may be on the bottom side, facing away from the heatsink. This may be stabilizing the cooling arrangement 1, in particular against bending in temperature differences. Additionally this area may be used to arrange components and or conductive paths.

The fifth layer may comprise fifth layer areas similar to the first layer areas 70a, 70b, 70c.

Additional components and/or conductive paths which are not shown in Fig. 2 may be arranged on the bottom side of such a substrate.

Connection lines between the substrate 11 and substrate 13 may be arranged outside or inside of the heatsink 76.

Such a configuration with further details, effects, advantages, and usage is described in PCT/EP2024/082605 filed on 15.11.2024 with the title" "Leistungselektronische Baueinheit mit Kühlung und Leistungsumwandler".

Multiple components 5 refers to any of electrical components, but with reference to the present invention may be understood as: a power input 12, a power output 14, and/or a switch element 16, a source contact 18, a drain contact 20, a gate contact 22, a switch power input 28, a switch power output 30, a signal input 32, a driver circuit 34, a driver signal contact 36, and/or a driver input 38, and/or a driver output 40, a driver gate contact 42, a coupling capacitor 54,58, 68.

Conductive paths 6 refers to any of electrical components, but with reference to the present invention may be understood as: a source path 24, a drain path 26, a driver input path 44, a driver output path 46, a signal path 48, a gate path 50.

The process of direct bonded copper (DBC) refers to a method of bonding a layer of copper directly onto a ceramic substrate, typically alumina (Al₂O₃) or aluminum nitride (AIN), using high temperatures. This process involves the oxidation of copper foil to form a uniform cupric oxide (CuO) layer, which is then placed in contact with the ceramic substrate. Their high thermal conductivity allows efficient heat dissipation from high-power components, ensuring reliable operation.

The integrated power module 10 with both sides metalized by direct bonded copper (DBC) refers to a compact and efficient assembly that incorporates power electronic components mounted on a ceramic substrate. This process involves bonding copper layers directly onto the ceramic substrate at high temperatures, creating a robust and thermally conductive interface. The integrated power module utilizes this DBC substrate to provide excellent thermal management, electrical insulation, and mechanical strength, making it ideal for high-power and high-heat applications.

The cooling fluid 9 refers to a fluid specifically formulated or selected for its ability to absorb and dissipate heat efficiently. This cooling fluid 9 may be used in various cooling systems to transfer thermal energy away from heat-generating components, thereby maintaining enhanced operating temperatures. The cooling fluid 9 may possess properties such as high thermal conductivity, low viscosity, and chemical stability to enhance its performance. The cooling fluid 9 may be water, ethylene glycol, propylene glycol, mineral oil, silicone oils, fluorocarbon oils.

The direct contact between multiple components 5, the driver circuit 34 and conductive paths 6 and the dielectric heat transfer coolant 3 may enhance the heat absorption efficiency, allowing for rapid and effective cooling during high-power operations.

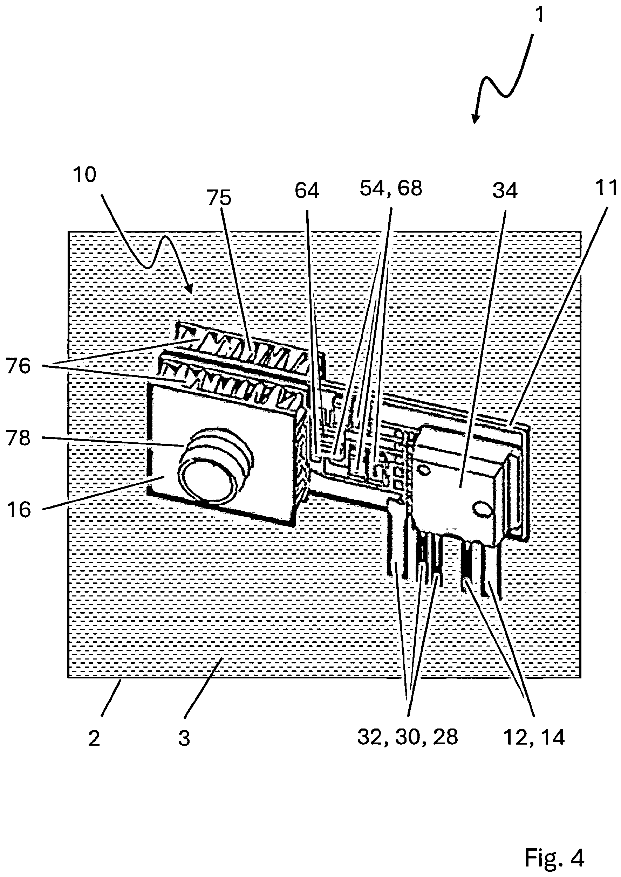

On Fig. 3 the cooling arrangement 1 for the integrated power module 10 showing the container 2 filled with the dielectric heat transfer coolant 3 is presented. The integrated power module 10 consists of the substrate 11 comprises a fluid inlet 77 and/or a fluid outlet 79 for the heatsink 76. So, cooling fluid 9 can by supplied to the heatsink 76 via the fluid inlet 77. To avoid the cooling fluid 9 leakage and to avoid mixing of the cooling fluid 9 and the dielectric heat transfer coolant 3, a seal 8 is arranged in the fluid inlet 77 and/or the fluid outlet 79. To improve the cooling of the integrated power module 10, the third layer 74 and/or the heatsink 76 comprises a cooling channel 78 and/or cooling fins 75 with respect to Fig. 4.

With the cooling fins 75, the heatsink 76 may be cooled by the the dielectric heat transfer coolant 3 additionally to the cooling with the cooling fluid 9 through the inside of the heatsink 76. In such a way, the aforementioned object may be solved in a very good way.

The fluid inlet 77 may be an equivalent of the "coolant supply 40 (Kühlmittelzuführung 40) " in the aforementioned PCT/EP2024/082605.

The fluid outlet 79 may be an equivalent of the "coolant drain 45 (Kühlmittelabführung 45)" in the aforementioned PCT/EP2024/082605.

Here, the fluid inlet 77 and/or the fluid outlet 79 may be arranged at least partly on the top of the substrate 11, that means on the same side as the components 5.

A seal 8 ensures that the cooling fluid 9 remains contained within the system, maintaining the integrity and reliability of the cooling arrangement. By preventing leakage, the seal 8 helps maintain the optimal level of cooling fluid, ensuring consistent thermal management and preventing system overheating. The seal 8 reduces the risk of coolant leakage, which could lead to electrical short circuits, corrosion, or mixing dielectric heat transfer coolant with cooling fluid.

The first layer 70 on Fig. 3 is divided into multiple first layer areas 70a, 70b, 70c. The power input 12 and/or the power output 14 and/or the switch element 16 and/or the source contact 18 and/or the drain contact and/or the gate contact and/or the switch power input 28 and/or the switch power output 30 and/or the signal input 32 and/or the driver circuit 34 and/or the driver signal contact 36 and/or the driver input 38 and/or the driver output 40 and/or the driver gate contact 42 may be arranged on different first layer areas 70a, 70b, 70c.

On Fig. 4 is presented the cooling arrangement 1 for the integrated power module 10 showing the container 2 filled with the dielectric heat transfer coolant 3, and on the integrated power module 10 two heatsinks 76 are provided, wherein a heatsink 76 is arranged at the third layer 74 and another heatsink 76 is arranged at the first layer 72. It is also possible that the integrated power module 10 only comprises one heatsink 76 at the first layer 72 and no heatsink at the third layer 76. The switch element 16 is arranged under the heatsink 76 at the first layer 72.

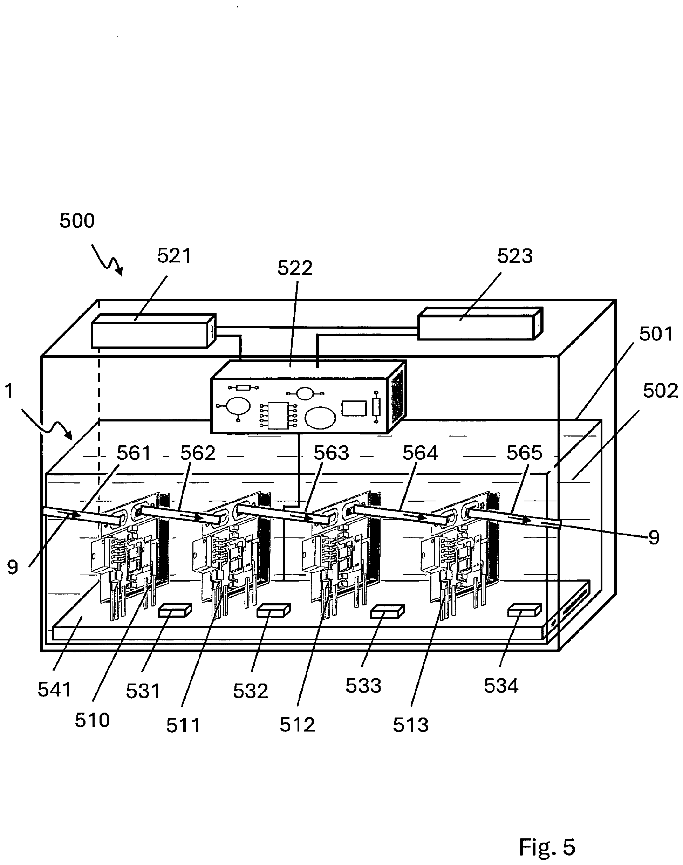

Fig. 5 shows a schematic view of a plasma supply unit 500. This plasma supply unit 500 comprises a main-PCB 541 with four integrated power modules 510, 511, 512, 513 arranged inside a container 501 with dielectric heat transfer coolant 502. On this main-PCB 541 are placed some electronical parts, such as a resistor 531, an inductivity 532, a capacitor 533, a diode 534 or other parts such as a transistor, copper lines and/or planes to connect those parts, and a possibility to integrate one or more of the power modules 510, 511, 512, 513. Those integrated power modules 510, 511, 512, 513 could be embodied as the integrated power module 10, as described in this application. That container 501 and the dielectric heat transfer coolant 502, could be embodied as the container 2 and dielectric heat transfer coolant 3, as described in this application. Those power modules 510, 511, 512, 513 are stacked close together with a distance smaller than the quarter wavelength of the frequency, with which the switching elements are switched on and off in use. Those power modules 510, 511, 512, 513 could be placed even more narrow as shown in Fig. 5. Those power modules 510, 511, 512, 513 could be placed in such a way, that the fluid inlet 77 and/or fluid outlet 79 of the heatsink 76 could be stacked directly together. This container 501 can be either smaller or larger and is usually adapted to the arrangement of power modules 510, 511, 512, 513, so as not to take more space than required. The dielectric heat transfer coolant 502 level also depends on the arrangement of the power modules 510, 511, 512, 513, it is required that the power modules 510, 511, 512, 513 are at least partially immersed in the coolant, or part of the group of connected power modules 510, 511, 512, 513 may be immersed in the dielectric heat transfer coolant 502. This is not shown in Fig. 5 but nevertheless a possible arrangement. Less space is needed then.

The fluid inlets 77 and the fluid outlets 79 of the power modules 510, 511, 512, 513 for the cooling fluid 9 are connected here by fluid tubes 561, 562, 563, 564, 565. The power modules 510, 511, 512, 513 may pe placed much closer to each other, such that those tubes 561 - 565 may be nearly as short as the height of the highest component, e.g. the driver circuit 34 in the shown example.

In an aspect, an arrangement is disclosed, where at least some or all of the tubes 561, 562, 563, 564, 565 are embodied as cooling channels 78, as shown in Fig. 4, e.g.. Such a configuration may have the advantage that the tubes are integral parts of the integrated power module 510, 511, 512, 513. This may make the fabrication and maintenance of the integrated power modules 510, 511, 512, 513 easier and more reliable.

This plasma supply unit 500 may comprise a control section 521. With such a device the switching elements could be controlled.

This plasma supply unit 500 may comprise a DC power supply part 522. With such a device the main-PCB may be supplied with DC-power.

This plasma supply unit 500 may comprise a measuring section 523. With such a device the supply unit 500 may be controlled in a close loop manner.

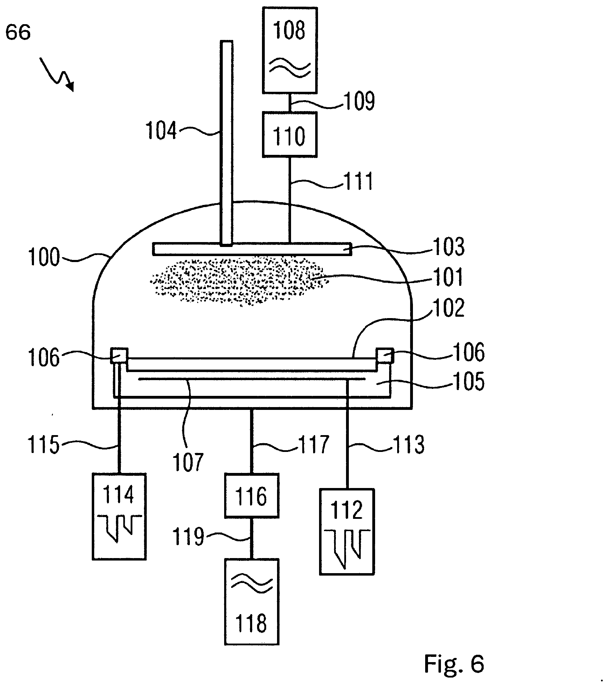

Fig. 6 shows a schematic view of a plasma process 66 with a plasma chamber 100 in which a plasma 101 is established in a plasma space. Such or similar systems are shown and described in US 2020 0118794 A1, US 10,474,184 B2, or US 10,607,813 B2 e.g..

In the plasma chamber 100 an upper electrode 103 may be positioned. A gas inlet and/or outlet, in particular a gas supply pipe 104 may be placed from the outside to the inside of the plasma chamber 100, in particular connected to the electrode 103.

A substrate 102, in particular a semiconductor wafer may be placed on a support 105 which comprises a substrate holder inside the plasma chamber 100. In use the substrate 102 may be processed by the plasma 101, e.g., in a process of etching, ashing, or deposition in particular with atomic layered deposition.

Etching process may be an extremely high challenge, for instance when the ratio between etched hole diameter and hole length is extremely low, < 1/100, e.g., as it is in deep etching often necessary. An electric conductive electrode 106 may be placed in the plasma chamber 100, in particular nearby the substrate 102, for example around the substrate 102. This electric conductive electrode 106 may be an edge ring which may be also called focus ring.

This electric conductive electrode 106 may be connected to a first power supply 114 via a first connection line 115. The first power supply 114 may be a DC pulsed power supply, where in particular the pulses may be of different length, different amplitude and shaped as described in US 9,287,086 B2 Fig. 11, 14, or US 10,474,184 B2, Fig. 2 e.g.. The first power supply 114 may be realized as a power supply unit 500 as described in this application. With the control of the first power supply 114 the electric conductive electrode 106 may be used additionally or alternatively as an ion energy and/or ion acceleration direction control as also described in US 9,287,086 B2 or US 10,474,184 B2.

A first radio-frequency (RF) power supply 118 may be electrically connected to the support 105 via a first power feeding rod 119 and a first matching unit 116 and a first connection unit 117. The first radio-frequency (RF) power supply 118 may be realized as a power supply unit 500 as described in this application.

A second radio-frequency (RF) power supply 108 may be electrically connected to the upper electrode 103 via a second power feeding rod 109 and a second matching unit 110 and a second connection unit 111. The second radio-frequency (RF) power supply 108 may be realized as a power supply unit 500 as described in this application.

An electrode 107 may be positioned in or nearby the support 105 and is electrically connected to a second power supply 112 via a second connection line 113. The second power supply 112 may be a DC pulsed power supply, where in particular the pulses may be of different length, different amplitude and shaped as described in US 9,287,086 B2 Fig. 11, 14, or US 10,474,184 B2, Fig. 2, e.g.. The second power supply 112 may be realized as a power supply unit 500 as described in this application.

The substrate 102 may be fixed at the support 105 via the electrode 107 which may work as an electrostatic chuck. With the control of the second power supply 112 the electrode 107 may be used additionally or alternatively as an ion energy and/or ion acceleration direction control as described in US 9,287,086 B2 or US 10,474,184 B2.

Some plasma treatment processes, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required.

Some plasma processes require not only pulsing, but pulse-to-pulse amplitude variation. Some plasma processes require the source to deliver high peak currents in order to obtain short voltage transition times. Most plasma processes present a load, which contains a capacitive component. Significant power loss is related to the pulse-by-pulse charging and discharging process of this load capacitance. Some plasma processes require pulse shaping as described in US 9,287,086 B2 Fig. 11, 14, or US 10,474,184 B2, Fig. 2, e.g..

## Claims

1. Cooling arrangement (1) comprising:
• an integrated power module (10);
• a container (2), in which the integrated power module (10) is arranged at least partly; and
• a dielectric heat transfer coolant (3), which is filled in the container (2) at least partly and which is in direct contact with the integrated power module (10) at least partly;
wherein the integrated power module (10) comprises:
i. a substrate (11), wherein the substrate (11) comprises: a first layer (70), a second layer (72), and a third layer (74), wherein the second layer (72) is placed between the first layer (70) and the third layer (74),
ii. multiple components (5) placed on the substrate (11), connected to each other by conductive paths (6), capable of generating heat during operation,
iii. a fluid inlet (77) for a cooling fluid (9), and
iv. a fluid outlet (79) for the cooling fluid (9).

2. Cooling arrangement (1) according to claim 1, wherein the first layer (70) is made of copper.

3. Cooling arrangement (1) according to any preceding claim, wherein the second layer (72) is made of ceramic.

4. Cooling arrangement (1) according to any preceding claim, wherein the third layer (74) is made of copper and/or aluminum.

5. Cooling arrangement (1) according to to any preceding claim, wherein the cooling arrangement (1) comprises a cooling fluid (9) flowable heatsink (76) made from metal sheets (76a, 76b, 76c), in particular copper sheets, and this heatsink (76) is arranged at the third layer (74).

6. Cooling arrangement (1) according to any preceding claim, wherein the first layer (70) comprises several first layer areas (70a, 70b, 70c).

7. Cooling arrangement (1) according to to any preceding claim, wherein the substrate (11) is metalized by direct bonded copper (8'), in particular on both sides.

8. Cooling arrangement (1) according to any preceding claim, wherein the dielectric heat transfer coolant (3) is a fluorocarbon-based fluid.

9. Cooling arrangement (1) according to any preceding claim, wherein the integrated power module (10) is configured to work as a fluid flowable heatsink (76) with cooling fluid (9).

10. Cooling arrangement (1) according to claim 3, wherein the integrated power module (10) is configured to use water or dielectric heat transfer coolant (3) as cooling fluid (9).

11. Cooling arrangement (1) according to any preceding claim, wherein the fluid inlet (77) have a seal (8) arranged to protect against cooling fluid (9) leakage.

12. Cooling arrangement (1) according to any preceding claim, wherein the fluid outlet (79) have a seal (8) arranged to protect against cooling fluid (9) leakage.

13. Cooling arrangement (1) according to any preceding claim, wherein multiple components (5) of the integrated power module (10) are one or more or a combination of the following:
• a power input (12),
• a power output (14),
• a switch element (16),
• a source contact (18),
• a drain contact (20),
• a gate contact (22),
• a switch power input (28),
• a switch power output (30),
• a signal input (32),
• a driver circuit (34),
• a driver signal contact (36),
• a driver input (38),
• a driver output (40),
• a driver gate contact (42),
• a coupling capacitor (54,58, 68).

14. Cooling arrangement (1) according to any preceding claim, wherein conductive paths (6) of the integrated power module (10) are one or more or a combination of the following:
• a source path (24),
• a drain path (26),
• a driver input path (44),
• a driver output path (46),
• a signal path (48),
• a gate path (50).

15. Cooling arrangement (1) for integrated power module (10) according to any preceding claim, wherein multiple components (5) and conductive paths (6) of the integrated power module (10) are arranged directly on the substrate (11).
